# EUROPEAN PATENT SPECIFICATION

(11) **EP 2 348 389 B1**
(45) Date of publication and mention of the grant of the patent: **16.04.2014**
(21) Application number: 09813196.4
(22) Date of filing: 13.07.2009
(51) Int. Cl.: G06F 3/041, H01L 51/50, G06F 3/02, G02F 1/13

(54) **KEYPAD APPARATUS, MOBILE DEVICE COMPRISING SAME, AND KEYPAD CONTROL METHOD**
TASTENFELD, MOBILGERÄT DAMIT UND STEUERUNGSVERFAHREN FÜR DAS TASTENFELD
CLAVIER, DISPOSITIF MOBILE COMPRENANT CE DERNIER ET PROCÉDÉ DE COMMANDE DU CLAVIER

(30) Priority: 09.09.2008 KR 20080088725; 29.05.2009 KR 20090047774
(43) Date of publication of application: 27.07.2011
(73) Proprietor: Neoviewkolon Co., Ltd., Chungcheongnam-Do 350-883 (KR)
(72) Inventor: PARK, Il-Ho, Chungcheongnam-Do 350-752 (KR); GYOUNG, Chung-Hyoun, Gyeonggi-do 469-842 (KR); KIM, Young-Eun, Seoul 133-846 (KR); KIM, Tae-Su, Busan 613-804 (KR); YM, Woo-Bin, Chungcheongnam-Do 350-751 (KR)
(74) Representative: Beck & Rössig European Patent Attorneys
(86) International application number: PCT/KR2009/003821
(87) International publication number: WO 2010/030074

(56) References cited:
- WO-A1-2007/107903
- WO-A2-2008/040323
- KR-A- 20020 079 438
- KR-A- 20020 087 359
- KR-B1- 100 573 895

## Description

### Technical Field

The present invention relates generally to keypads, and, more particularly, to a keypad device, which enables the structure of a product to be slim and compact by employing Organic Light-Emitting Diodes (OLEDs) or Transparent OLEDs (TOLEDs), a mobile device having the keypad device, and a method of controlling the keypad device.

### Background Art

In general, mobile communication terminals such as mobile phones are equipped with keypads which are used for various types of information search, transmission and reception, or character input.

A typical conventional keypad is constructed by attaching a base sheet on a Printed Circuit Board (PCB) having printed circuit patterns, placing dome switches and Light-Emitting Diodes (LEDs) for implementing backlight on the base sheet, and placing an upper sheet having printed Korean consonants and vowels, the English alphabet, numbers and the like thereon.

However, the conventional keypad is problematic in that the thickness thereof cannot be reduced due to the structural characteristics thereof In more detail, circuit patterns can be implemented on the PCB of the conventional keypad only when the PCB is of a minimum thickness, the dome switches can be pressed and then restored to their original positions only when the dome switches have a specific height, and the thickness of LED lamps is added thereto. Accordingly, the conventional keypad is problematic in that the overall thickness thereof must be equal to or greater than a specific thickness.

As a result, when the structure of the conventional keypad is applied to mobile communication terminals such as mobile phones, the overall thickness and size of the mobile communication terminals are increased, so that they cannot be implemented in slim and compact forms.

### Disclosure

### Technical Problem

Accordingly, the present invention has been made keeping in mind the above problems occurring in the prior art, and an object of the present invention is to provide a keypad device which enables the structure of a product to be slim and compact by employing OLEDs or TOLEDs.

Another object of the present invention is to provide a mobile device having the keypad device.

Still another object of the present invention is to provide a method of controlling the keypad device.

### Technical Solution

In order to accomplish the above object, the present invention provides a keypad device, including a touch panel; a Transparent Organic Light-Emitting Diode (TOLED) panel placed under the touch panel; a control unit electrically connected to the touch panel and the TOLED panel, and configured to detect an electric signal related to a touch point of the touch panel and cause a pixel of the TOLED panel corresponding to the touch point to emit light; and a reflective sheet placed under the TOLED panel, patterned with keypad information, and configured to reflect keypad information corresponding to the light emitting pixel of the TOLED panel, thereby displaying this keypad information.

The TOLED panel may include a substrate; a first electrode formed on the substrate; an organic layer formed on the first electrode; a second electrode formed on the organic layer; and a transparent layer formed between the organic layer and the second electrode and/or on a top of the second electrode, and configured to comprise any one selected from the group consisting of oxides, nitrides, salts and mixtures thereof

The oxides may include MoO₃, ITO, IZO, IO, ZnO, TO, TiO₂, SiO₂, WO₃, Al₂O₃, Cr₂O₃, TeO₂, and SrO₂.

The nitrides may include SiN and AIN.

The salts may include Cs₂CO₃, LiCO₃, KCO₃, NaCO₃, LiF, CsF, and ZnSe.

The transparent layer may have a thickness which is equal to or greater than 0.1 nm and less than 100 nm.

The organic layer may include an electron transporting layer which is doped with any one selected from the group consisting of low-work-function metals and mixtures thereof in order to facilitate injection of electrons from the second electrode.

The low-work-function metals may include Cs, Li, Na, K, and Ca.

The mixtures may include Li-Al, LiF, CsF, and Cs₂CO₃.

The TOLED panel may exhibit a transmittance ranging from 70 to 99% depending on wavelength (nm).

In order to accomplish the above object, the present invention provides a mobile device comprising the keypad device.

In order to accomplish the above object, the present invention provides a method of controlling a keypad device, including a control unit detecting an electric signal related to a touch point of a touch panel; if the electric signal generated in the touch panel is detected, causing a corresponding pixel to emit light by applying driving voltage to the corresponding pixel of the TOLED panel corresponding to the touch point; and a reflective sheet patterned with keypad information reflecting keypad information corresponding to a light emitting pixel of the TOLED panel, thereby displaying this keypad information.

### Advantageous Effects

According to the above-described invention, a keypad device enables the structure of a mobile device product, such as a mobile phone or a PMP, to be slim and compact using OLEDs or TOLEDs.

Furthermore, according to the present invention, the TOLED panel is formed by forming the transparent layer, including any one selected from the group consisting of oxides, nitrides, salts and mixtures thereof, between the organic layer and the second electrode (cathode electrode) and/or on the top of the second electrode, thereby realizing double-sided light emission and improving transmittance.

Moreover, according to the present invention, the transparent layer is made of any one selected from the group consisting of oxides, nitrides, salts and mixtures thereof, so that the increase in the internal resistance of the second electrode can be prevented, thereby improving the electrical performance of products.

### Description of Drawings

The above and other objects, features and advantages of the present invention will be more clearly understood from the following detailed description taken in conjunction with the accompanying drawings, in which:
FIG. 1 is an exploded perspective view showing the principal portions of a keypad device according to an embodiment of the present invention;
FIG. 2 is a block diagram showing the configuration of the keypad device according to the embodiment of the present invention;
FIG. 3 is a diagram illustrating an example of the operating status of the touch pad of the keypad device according to the embodiment of the present invention when it is not in operation;
FIG. 4 is a diagram showing an example of the operating status of the touch pad of the keypad device according to the embodiment of the present invention when it is in operation;
FIG. 5 is a flowchart illustrating a keypad control method according to an embodiment of the present invention;
FIG. 6 is a sectional view showing the TOLED panel of the keypad device according to the present invention;
FIG. 7 is a graph showing transmittance depending on the transparent layer of the TOLED panel;
FIG. 8 is a graph showing luminance depending on the transparent layer of the TOLED panel;
FIG. 9 is a graph showing transmittance when transparent layers have been formed in the TOLED panel using an oxide, a salt and a mixture thereof, respectively; and
FIG. 10 is a flowchart showing a method of manufacturing the TOLED of the keypad device according to the present invention.

### Best Mode

Reference now should be made to the drawings, in which the same reference numerals are used throughout the different drawings to designate the same or similar components.

A keypad device, a mobile device having the keypad, and a keypad control method according to preferred embodiments of present invention will be described in detail below with reference to the accompanying drawings. For reference, if in the following description of the present invention, detailed descriptions of well-known functions or configurations may unnecessarily make the gist of the present invention obscure, the detailed descriptions will be omitted.

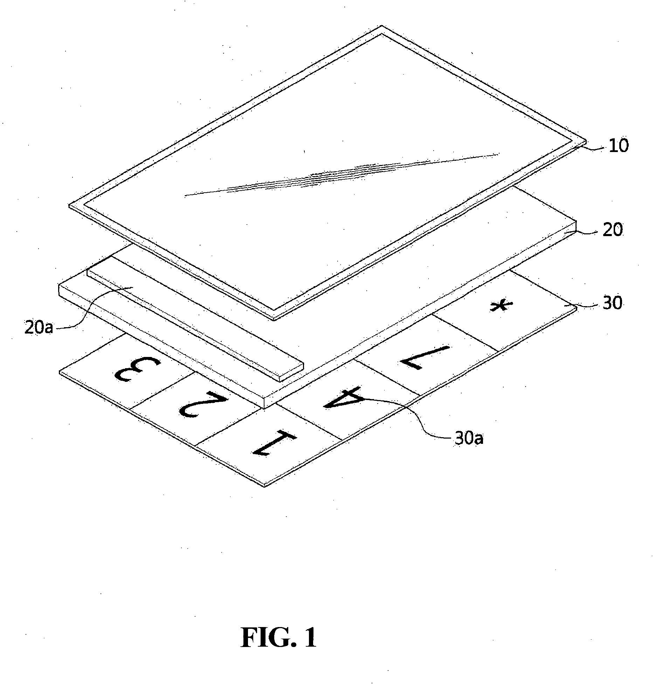

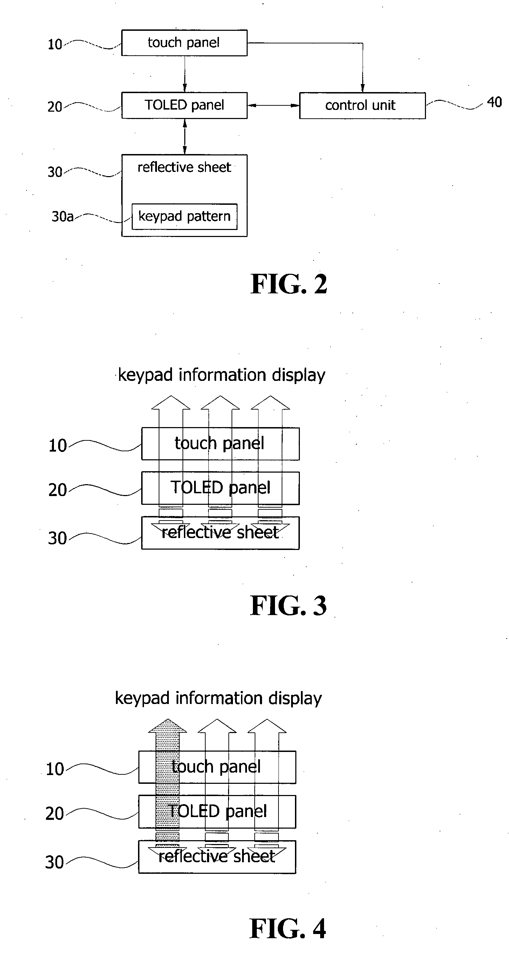

FIG. 1 is an exploded perspective view showing the principal portions of a keypad device according to an embodiment of the present invention, and FIG. 2 is a block diagram showing the configuration of the keypad device according to the embodiment of the present invention.

As shown in FIGS. 1 and 2, the keypad device according to the embodiment of the present invention includes a touch panel 10, a TOLED panel 20, a reflective sheet 30, and a control unit 40.

The touch panel 10 is an input device which generates an electric signal related to a touch point using a capacitance method in which an analyzer is pressed by a pen or the hand, a conductive film is pressed by the force of the pen or hand, and then the conductive film is brought into contact with X-Y electrode patterns, so that the voltage difference between the X-Y electrode patterns is detected. Since the technology of the touch panel 10 is well known and can be easily understood, a detailed description will be omitted here.

The touch panel 10 is electrically connected to the driver IC 20a of the TOLED panel 20 and the control unit 40, which will be described later.

An electric signal generated in the touch panel 10 drives the electrode of the corresponding pixel of the TOLED panel 20 corresponding to the touch point through the control unit 40 which executes a program.

The TOLED panel 20 is formed by coating a transparent ITO positive electrode with a hole transporting layer, an emissive layer and an electron transporting layer, forming a transparent negative electrode by applying Mg-Ag (composition ratio = 5:95) having a thickness less than 100 Å, and then coating the negative electrode with an ITO film so as to compensate for conductivity, function as a protective layer and maintain transparency. The above-described TOLED panel 20 will be described in more detail when it is described with reference to FIGS. 11 to 15.

The TOLED panel 20 is placed under the touch panel 10, and a pixel corresponding to the touch point of the touch panel 10 emits light.

The driver IC 20a connected to the control unit 40 is mounted on the TOLED panel 20.

The reflective sheet 30 is placed under the TOLED panel 20 so that it can reflect the information of the keypad pattern 30a corresponding to the light emitting pixel of the TOLED panel 20, thus resulting in displaying the information. For example, in the case of a mobile communication terminal such as a mobile phone, the keypad information 30a includes Korean consonants and vowels, the English alphabet, numbers and special characters. The entire region may be divided into individual regions, and the individual regions may be patterned on the reflective sheet 30.

The control unit 40 is electrically connected to the touch panel 10 and the TOLED panel 20. The control unit 40 detects an electric signal related to a touch point of the touch panel 10, and applies voltage to the driver IC 20a of the TOLED panel 20 in order to cause the pixel of the TOLED panel 20 corresponding to the touch point to emit light.

Although not shown in the drawings, the mobile device of the present invention may include the keypad device of this embodiment in which the TOLED panel 20 and the touch panel 10 are provided over the thin reflective sheet 30 having patterned keypad information, so that keypad information corresponding to a light emitting pixel of the TOLED panel 20 can be reflected by the reflective sheet 30 and then displayed. Accordingly, by applying the TOLED panel 20 and the reflective sheet 30 having patterned keypad information to the keypad, the structure of a mobile device product, such as a mobile phone or a PMP, can be made slim and compact.

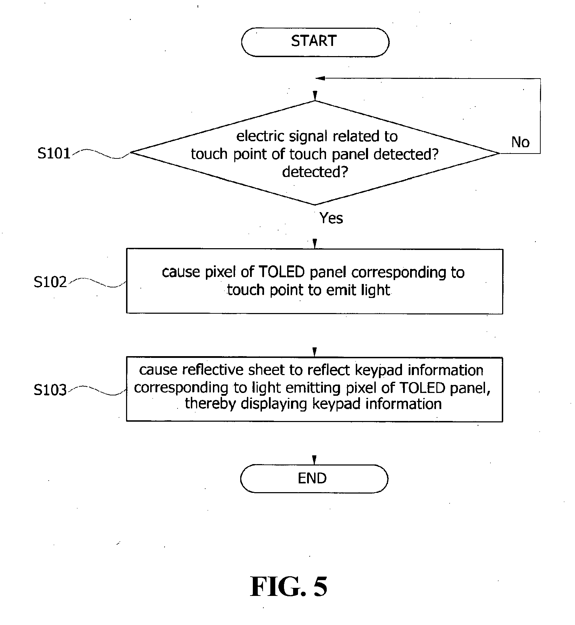

FIG. 3 is a diagram illustrating an example of the operating status of the touch pad of the keypad device according to the embodiment of the present invention when it is not in operation, FIG. 4 is a diagram showing an example of the operating status of the touch pad of the keypad device when it is in operation, and FIG. 5 is a flowchart illustrating a keypad control method.

When the touch panel 10 of the keypad device is not operating, that is, when a user is not touching the touch panel 10, an electric signal is not generated in the touch panel 10, so that the entire region of the TOLED panel 20 does not emit light, with the result that the overall keypad information is not displayed. Alternatively, as shown in FIG. 3, the minimum electric signal is generated in the touch panel 10, so that the entire region of the TOLED panel 20 emits a small amount of light, with the result that the overall keypad information is reflected by the reflective sheet 30 having patterned keypad information and is dimly displayed.

As shown in FIGS. 4 and 5, when a user presses a desired touch point of the touch panel 10, the touch panel 10 operates and generates an electric signal related to the touch point. The control unit 40 detects the occurrence of an electric signal related to a touch point of the touch panel 10 at step S 101. In more detail, the touch panel 10 generates an electric signal related to the touch point using a capacitance method in which an analyzer is pressed by a pen or the hand, a conductive film is pressed by the force of the pen or hand, and then the conductive film is brought into contact with X-Y electrode patterns, so that the voltage difference between the X-Y electrode patterns is detected. The electric signal generated as described above is detected by the control unit 40 which executes a program.

Thereafter, when the control unit 40 detects an electric signal related to the touch point of the touch panel 10, the control unit 40 causes only the pixel of the TOLED panel 20 corresponding to the touch point of the touch panel 10 to emit light by applying voltage to the pixel of the TOLED panel 20 corresponding to the touch point at step S102.

Thereafter, the reflective sheet 30 having patterned keypad information reflects only keypad information corresponding to the light emitting pixel of the TOLED panel 20, thus resulting in displaying it brightly at step S103. Alternatively, the entire region of the TOLED panel 20 emits a small amount of light and only the touched pixel emits a large amount of light, so that only corresponding keypad information is reflected and displayed brightly.

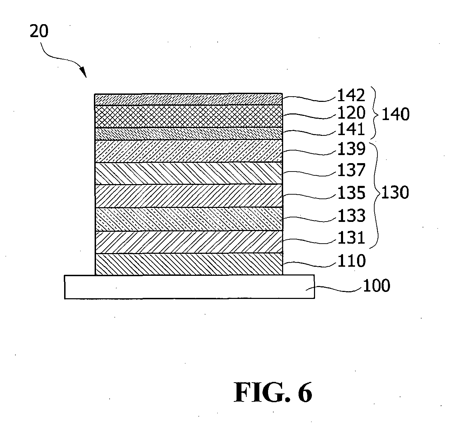

FIG. 6 is a sectional view showing the TOLED panel of the keypad device according to the present invention.

As shown in FIG. 6, the TOLED panel 20 of the keypad device according to the present invention includes a substrate 100, a first electrode 110, a second electrode 120, an organic layer 130, and a transparent layer 140.

The substrate 100 supports the first electrode 110, the second electrode 120, the organic layer 130 and the transparent layer 140. The substrate 100 is made of glass or plastic material having transparency so that emitted light can pass through the substrate 100.

The first electrode 120 is commonly referred to as a lower electrode, and is formed on the substrate 100. The first electrode 110 is an anode, that is, a positive (+) electrode, and is formed on the substrate 100 using any one of a sputtering method, an ion plating method, and a thermal evaporation method using an electron (e) gun. Here, although an indium-tin oxide indium tin-oxide electrode having transparency is used as the first electrode 110 according to the embodiment of the present invention, an indium-zinc oxide electrode having transparency may be used.

The second electrode 120, which is opposite to the first electrode 110, is commonly referred to as an upper electrode, and is formed on the organic layer 130. The second electrode 120 is a cathode, that is, a negative (-) electrode, which is the opposite of the first electrode 30, that is, a positive (+) electrode. The second electrode 120 is made of any one selected from a group consisting of silver (Ag), aluminum (Al), and a magnesium-silver (Mg-Ag) alloy having transparency.

The organic layer 130 is interposed between the first electrode 110 and the second electrode 120, and emits light using electrical conduction between the first electrode 110 and the second electrode 120. The organic layer 130 includes a Hole Injection Layer (HIL) 131, a Hole Transporting Layer (HTL) 133, an EMissive Layer (EML) 135, an Electron Transporting Layer (ETL) 137, and an Electron Injection Layer (EIL) 139 so that the organic layer 130 can emit light using the electrical conduction between the first electrode 110 and the second electrode 120.

Here, the organic layer 130 is interposed between the first electrode 110 and the second electrode 120 using any one of a spin coating method, a thermal evaporation method, a spin casting method, a sputtering method, an electron (e)-beam evaporation method and a Chemical Vapor Deposition (CVD) method.

The hole injection layer 131 functions to enable electrons to be injected from the first electrode 110, and the hole transporting layer 133 functions as the movement path of holes injected from the hole injection layer 131 so that the injected holes can meet the electrons of the second electrode 120.

The electron injection layer 139 functions to enable electrons to be injected from the second electrode 120, and the electron transporting layer 137 functions as the movement path of electrons injected from the electron injection layer 139 so that the injected electrons meet the holes, moving from the hole transporting layer 133, in the emissive layer 135.

In order to facilitate the injection of electrons from the second electrode 120, the electron transporting layer 137 may be doped with any one selected from the group consisting of low-work-function metals and mixtures thereof, which can be applied regardless of the existence of the electron injection layer 139.

Here, the low-work-function metals may include Cs, Li, Na, K, and Ca, and the mixtures thereof may include Li-Al, LiF, CsF, and Cs₂CO₃.

Meanwhile, the emissive layer 135 is interposed between the hole transporting layer 133 and the electron transporting layer 137, and emits light using holes from the hole transporting layer 133 and electrons from the electron transporting layer 137. That is, the emissive layer 135 emits light using the holes and the electrons which meet on the boundary surface between the hole transporting layer 133 and the electron transporting layer 137.

The transparent layer 140 may be formed between the organic layer 130 and the second electrode 120 and/or on the second electrode 120. For example, the transparent layer 140 may be formed on both the top and bottom surfaces of the second electrode 120 or on the top or bottom surface of the second electrode 120.

Although this embodiment shows an example of a configuration in which the transparent layer 140 is formed on both the top and bottom surfaces of the second electrode 120, the present invention is not limited thereto, but a configuration in which the transparent layer 140 is formed on only the top or bottom surface of the second electrode 120 may be applied to the present invention.

The transparent layer 140 may include a first transparent layer 141 formed between the organic layer 130 and the second electrode 120 and a second transparent layer 142 formed on the top surface of the second electrode 120.

Preferably, the first transparent layer 141 may be formed between the electron injection layer 139 and second electrode 120 of the organic layer 130, or may be formed in the electron injection layer 139 itself Furthermore, the second transparent layer 142 may be placed on the top surface of the second electrode 120 which faces the first transparent layer 141.

Here, the transparent layer 140 functions to enable the second electrode 120 to have both transparency and high transmittance. Furthermore, the transparent layer 140 is configured in the form of a thin film, and thus reduces the surface resistance of the second electrode 120, thereby preventing the performance of the TOLED panel 20 from being deteriorated. The characteristics of the transparent layer 140 will be described in detail with reference to FIGS. 12 to 14 after oxides, nitrides, salts, and mixtures thereof have been described.

The transparent layer 140 according to the present invention may include any one selected from the group consisting of oxides, nitrides, salts and mixtures thereof

Here, the oxides may include MoO₃, ITO, IZO, IO, ZnO, TO, TiO₂, SiO₂, WO₃, Al₂O₃, Cr₂O₃, TeO₂, and SrO₂. Furthermore, the nitrides may include SiN, and AIN. Furthermore, the salts may include Cs₂CO₃, LiCO₃, KCO₃, NaCO₃, LiF, CsF, and ZnSe.

Although it is preferable to use the oxide, the nitride, the salt or the mixture included in the transparent layer 140 because excellent transmittance and luminance can be exhibited, as shown in FIGS. 12 to 14, any material other than those materials may be included in the transparent layer 140 as long as the material enables the second electrode 120 to have both transparency and high transmittance.

Although the first transparent layer 141 and second transparent layer 142 of the transparent layer 140 are made of the same material, they may be made of different materials. For example, the first transparent layer 141 may include an oxide, and the second transparent layer 142 may include a nitride, a salt or a mixture thereof Alternatively, the first transparent layer 141 may include a nitride, and the second transparent layer 142 may include an oxide, a salt or a mixture thereof Alternatively, the first transparent layer 141 may include a salt, and the second transparent layer 142 may include an oxide, a nitride or a mixture thereof.

It is preferred that the thickness of the transparent layer 140 be equal to or greater than 0.1 nm and less than 100 nm. The reason for limiting the thickness of the transparent layer 140 is, for example, that when the thickness of the transparent layer 140 is less than 0.1 nm, the transmittance increases and the resistance also increases in proportion thereto, so that the performance of the TOLED panel 20 is deteriorated.

In contrast, when the thickness of the transparent layer 140 is equal to or greater than 100 nm, the performance is not deteriorated due to decrease in resistance, but the transmittance decreases due to increase in the thickness of the transparent layer 140. Meanwhile, it is preferred that the transparent layer 140 according to the embodiment of the present invention be formed using thermal evaporation.

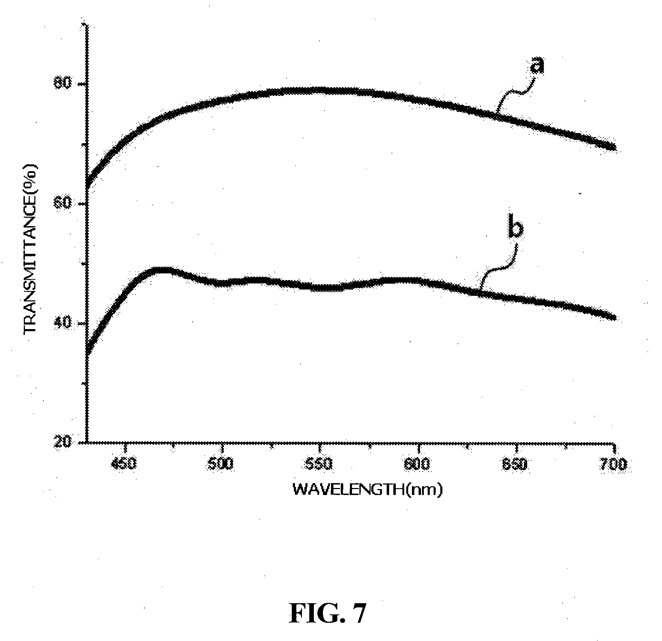

Referring to FIGS. 7 to 9, the characteristics of the TOLED panel 20 having the above-described configuration according to the present invention will be described below.

FIG. 7 is a graph showing transmittance depending on whether the transparent layer 140 is present in the TOLED panel 20 according to the present invention. Here, in FIG. 7, 'a' denotes a curve for the TOLED panel 20 with the transparent layer 140 according to the present invention, and 'b' denotes a curve for a TOLED panel without the transparent layer 140, which is different from that of the present invention.

The TOLED panel 20 according to the present invention may exhibit a transmittance ranging from 70 to 99% depending on the wavelength (nm). For example, as shown in FIG.7, with regard to the transmittance depending on the wavelength (nm), the TOLED panel 20 according to the present invention exhibits a transmittance of about 80% at a wavelength of 550 nm, and the TOLED panel without the transparent layer 140 exhibits a transmittance of about 47%. From these results, it can be seen that the transmittance of the TOLED panel 20 with the transparent layer 140 is 1.7 times as high as that of the TOLED panel without the transparent layer 140.

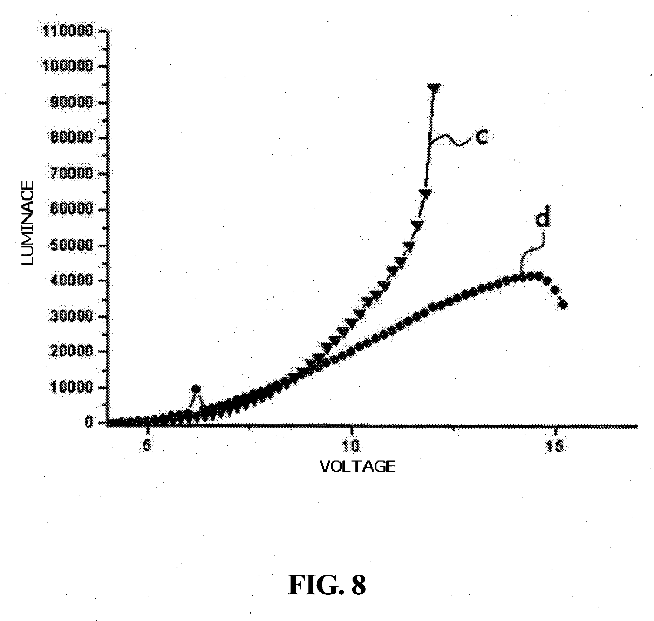

FIG. 8 is a graph showing luminance depending on whether the transparent layer 140 is present in the TOLED panel 20. In FIG. 8, 'c' denotes a curve for the TOLED panel 20 according to the present invention, and 'd' denotes a curve for the TOLED panel without the transparent layer 140.

With regard to the luminance depending on a voltage of 10 V, the TOLED panel 20 with the transparent layer 140 exhibits about 25000, and the TOLED panel without the transparent layer 140 exhibits about 20000. Accordingly, it can be seen that there is a 1.25 times difference in the luminance depending on whether the transparent layer 140 is present.

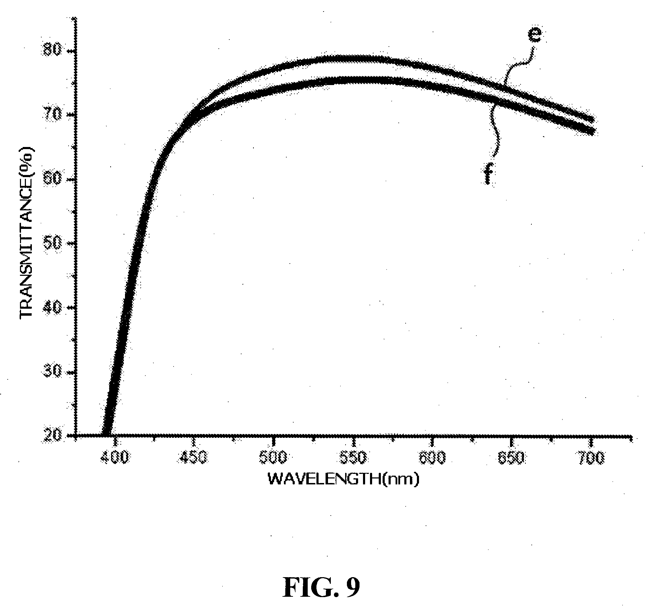

In FIG. 9, curve 'e' shows transmittance for the transparent layer 140 made of an oxide, such as MoO₃, ITO, IZO, IO, ZnO, TO, TiO₂, SiO₂, WO₃, Al₂O₃, Cr₂O₃, TeO₂, or SrO₂, and curve 'f' shows transmittance for the transparent layer 140 made of a salt, such as Cs₂CO₃, LiCO₃, KCO₃, NaCO₃, LiF, CsF, or ZnSe.

As shown in FIG. 9, a transmittance of about 80% is obtained when the transparent layer 140 is made of an oxide, while a transmittance of about 75% is obtained when the transparent layer 140 is made of a salt. Although the transmittance for the transparent layer 140 made of an oxide is 5% higher than that for the transparent layer 140 made of a salt, this is merely a small difference, so that it may be preferable to selectively use an oxide, a salt and a mixture thereof as in the embodiment of the present invention.

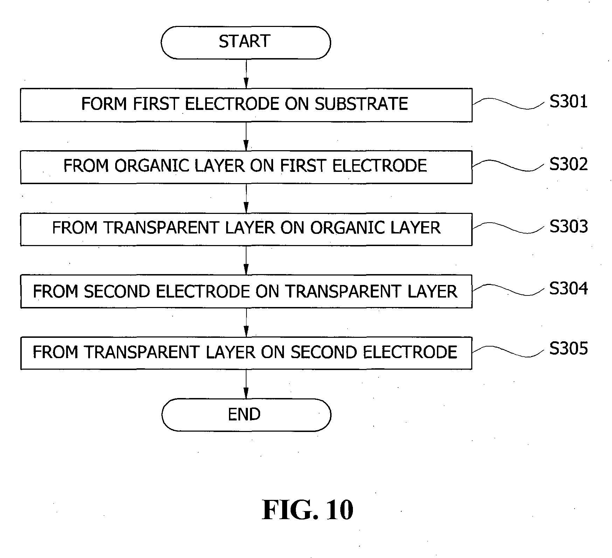

A method of manufacturing the TOLED panel 20 according to the present invention will be described below with reference to FIG. 10.

First, the first electrode 110, that is, a positive (+) electrode, is formed on the substrate 100 at step S301.

After the first electrode 110 has been formed on the substrate 100, the organic layer 130 is formed on the first electrode 110 at step S302. Here, the organic layer 130 formed on the first electrode 110 is configured in the sequence of the hole injection layer 131, the hole transporting layer 133, the emissive layer 135, the electron transporting layer 137 and the electron injection layer 139.

Thereafter, the first transparent layer 141 is formed on the organic layer 130 at step S303. In an embodiment of the present invention, the first transparent layer 141 may include an oxide such as MoO₃, ITO, IZO, IO, ZnO, TO, TiO₂, SiO₂, WO₃, Al₂O₃, Cr₂O₃, TeO₂, or SrO₂. The thickness of the first transparent layer 141 is equal to or greater than 0.1 nm and less than 100 nm in view of resistance and transmittance.

Thereafter, the second electrode 120 is formed on the first transparent layer 141 at step S304. The second electrode 120 is a negative (-) electrode, and is formed of a thin metal film. The thin metal film used as the second electrode second electrode 120 is made of any one selected from the group consisting of Ag, Al and an Mg-Ag alloy.

Thereafter, the second transparent layer 142 is formed on the second electrode 120 at step S305. The second transparent layer 142 may include an oxide, as at step S303'. However, the second transparent layer 142 formed on the second electrode 120 may include any one selected from the group consisting of nitrides such as SiN and AIN, salts such as Cs₂CO₃, LiCO₃, KCO₃, NaCO₃, LiF, CsF and ZnSe, and mixtures thereof

Accordingly, the transparent layer 140 is formed with the second electrode 120 disposed therein, so that double-sided light emission can be implemented and the transmittance can be improved.

Furthermore, the transparent layer 140 may be formed to adjust the thickness of the second electrode 120, so that the transmittance and the electrical performance can be improved.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

### Industrial Applicability

The present invention is used to a mobile device product, such as a mobile phone or a PMP, having keypad structure which is slim and compact using TOLED.

## Claims

1. A keypad device, comprising:
a touch panel;
a Transparent Organic Light-Emitting Diode (TOLED) panel placed under the touch panel;
a control unit electrically connected to the touch panel and the TOLED panel, and configured to detect an electric signal related to a touch point of the touch panel and cause a pixel ofthe TOLED panel corresponding to the touch point to emit light;
**characterized by**
a reflective sheet placed under the TOLED panel, patterned with keypad information, and configured to reflect keypad information corresponding to the light emitting pixel of the TOLED panel, thereby displaying this keypad information.

2. The keypad device according to claim 1, wherein the TOLED panel comprises:
a substrate;
a first electrode formed on the substrate;
an organic layer formed on the first electrode;
a second electrode formed on the organic layer; and
a transparent layer formed between the organic layer and the second electrode and/or on a top of the second electrode, and configured to comprise any one selected from the group consisting of oxides, nitrides, salts and mixtures thereof

3. The keypad device according to claim 2, wherein the oxides comprise MoO₃, ITO, IZO, IO, ZnO, TO, TiO₂, SiO₂, WO₃, Al₂O₃, Cr₂O3, TeO₂, and SrO₂.

4. The keypad device according to claim 2, wherein the nitrides comprise SiN and AIN.

5. The keypad device according to claim 2, wherein the salts comprise Cs₂CO₃, LiCO₃, KCO₃, NaCO₃, LiF, CsF, and ZnSe.

6. The keypad device according to claim 2, wherein the transparent layer has a thickness which is equal to or greater than 0.1 nm and less than 100 nm

7. The keypad device according to claim 2, wherein the organic layer comprises an electron transporting layer which is doped with any one selected from the group consisting of low-work-function metals and mixtures thereof in order to facilitate injection of electrons from the second electrode.

8. The keypad device according to claim 7, wherein the low-work-function metals comprise Cs, Li, Na, K, and Ca.

9. The keypad device according to claim 7, wherein the mixtures comprise Li-Al, LiF, CsF, and Cs₂CO₃.

10. The keypad device according to claim 2, wherein the TOLED panel exhibits a transmittance ranging from 70 to 99% depending on wavelength (nm).

11. A mobile device comprising the keypad device set forth in any one of claims 1 to 10.

12. A method of controlling a keypad device, comprising:
a control unit detecting an electric signal related to a touch point of a touch panel;
if the electric signal generated in the touch panel is detected, causing a corresponding pixel to emit light by applying driving voltage to the corresponding pixel of the TOLED panel corresponding to the touch point;
**characterized by**
a reflective sheet patterned with keypad information reflecting keypad information corresponding to a light emitting pixel of the TOLED panel, thereby displaying this keypad information.

## Patentansprüche

1. Tastaturvorrichtung, umfassend:
einen Berührungsbildschirm;
ein TOLED-Panel (Transparent Organic Light-Emitting Diode), das unter dem Berührungsbildschirm angeordnet ist;
eine Steuereinheit, die elektrisch mit dem Berührungsbildschirm und dem TOLED-Panel verbunden und dazu konfiguriert ist, ein elektrisches Signal zu ermitteln, das sich auf einen Berührungspunkt des Berührungsbildschirms bezieht, und ein Pixel des TOLED-Panels, das dem Berührungspunkt entspricht, dazu zu veranlassen, Licht zu emittieren;
**gekennzeichnet durch**
eine reflektierende Folie, die unter dem TOLED-Panel angeordnet, mit Tastaturinformationen gemustert und dazu konfiguriert ist, Tastaturinformationen zu reflektieren, die dem lichtemittierenden Pixel des TOLED-Panels entsprechen, um dadurch diese Tastaturinformation anzuzeigen.

2. Tastaturvorrichtung nach Anspruch 1, wobei das TOLED-Panel umfasst:
ein Substrat;
eine erste Elektrode, die auf dem Substrat ausgebildet ist;
eine organische Schicht, die auf der ersten Elektrode ausgebildet ist;
eine zweite Elektrode, die auf der organischen Schicht ausgebildet ist; und
eine transparente Schicht, die zwischen der organischen Schicht und der zweiten Elektrode und/oder auf der zweiten Elektrode ausgebildet und dazu konfiguriert ist, ein Element aus der Gruppe zu umfassen, die aus Oxiden, Nitriden, Salzen und Mischungen daraus besteht.

3. Tastaturvorrichtung nach Anspruch 2, wobei die Oxide MoO₃, ITO, IZO, IO, ZnO, TO, TiO₂, SiO₂, WO₃, Al₂O3, Cr₂O₃, TeO₂, und SrO₂ umfassen.

4. Tastaturvorrichtung nach Anspruch 2, wobei die Nitride SiN und AlN umfassen.

5. Tastaturvorrichtung nach Anspruch 2, wobei die Salze Cs₂CO₃, LiCO₃, KCO₃, NaCO₃, LiF, CsF, und ZnSe umfassen.

6. Tastaturvorrichtung nach Anspruch 2, wobei die transparente Schicht eine Dicke aufweist, die gleich oder größer als 0,1 nm und kleiner als 100 nm ist.

7. Tastaturvorrichtung nach Anspruch 2, wobei die organische Schicht eine Elektronenleitungsschicht umfasst, die mit einem Element dotiert ist, das aus der Gruppe bestehend aus Metallen mit niedriger Austrittsarbeit und Mischungen daraus gewählt wird, um eine Elektroneninjektion von der zweiten Elektrode zu ermöglichen.

8. Tastaturvorrichtung nach Anspruch 7, wobei die Metalle mit niedriger Austrittsarbeit Cs, Li, Na, K und Ca umfassen.

9. Tastasturvorrichtung nach Anspruch 7, wobei die Mischungen Li-Al, LiF, CsF und Cs₂CO₃ umfassen.

10. Tastasturvorrichtung nach Anspruch 2, wobei das TOLED-Panel einen Transmissionsgrad aufweist, der je nach Wellenlänge (nm) zwischen 70 und 99 % liegt.

11. Mobilgerät, das die Tastaturvorrichtung nach einem der Ansprüche 1 bis 10 umfasst.

12. Verfahren zum Steuern einer Tastaturvorrichtung, umfassend:
Ermitteln eines elektrischen Signals bezüglich eines Berührungspunktes eines Berührungsbildschirms durch eine Steuereinheit;
wenn das in dem Berührungsbildschirm erzeugte elektrische Signal ermittelt wurde, Veranlassen eines korrespondierenden Pixels, Licht zu emittieren, durch Anlegen einer Steuerspannung an das korrespondiere Pixel des TOLED-Panels, das dem Berührungspunkt entspricht;
**gekennzeichnet durch**
eine mit Tastaturinformationen gemusterte reflektierende Folie, die Tastasturinformationen reflektiert, die einem lichtemittierenden Pixel des TOLED-Panels entsprechen, um **dadurch** diese Tastaturinformationen anzuzeigen.

## Revendications

1. Dispositif à clavier comprenant :
un panneau tactile ;
un panneau à diode électroluminescente organique transparente (TOLED) placé sous le panneau tactile ;
une unité de commande reliée électriquement au panneau tactile et au panneau TOLED et configurée pour détecter un signal électrique relatif à un point de palpage du panneau tactile et qui fait en sorte qu'un pixel du panneau TOLED correspondant au point de palpage émet de la lumière,
**caractérisé par**
une feuille réfléchissante placée sous le panneau TOLED, modelée avec des informations pour clavier et configurée pour réfléchir des informations pour clavier correspondantes au pixel émettant de la lumière du panneau TOLED en affichant ces informations pour clavier.

2. Dispositif à clavier selon la revendication 1 dans lequel le panneau TOLED comprend :
un substrat,
un première électrode formée sur le substrat,
une couche organique formée sur la première électrode,
une seconde électrode formée sur la couche organique et
une couche transparente formée entre la couche organique et la seconde électrode et/ou sur un dessus de la seconde électrode et configurée pour comprendre l'un quelconque des éléments sélectionnés dans le groupe comportant les oxydes, les nitrures, les sels et mélanges de ceux-ci.

3. Dispositif à clavier selon la revendication 2 dans lequel les oxydes comprennent le MoO₃, l'ITO, l'IZO, l'IO, le ZnO, le TO, le TiO₂, le SiO₂, le WO₃, l'Al₂O₃, le Cr₂O₃, le TeO₂ et le SrO₂.

4. Dispositif à clavier selon la revendication 2 dans lequel les nitrures comprennent le SiN et l'AIN.

5. Dispositif à clavier selon la revendication 2 dans lequel les sels comprennent le Cs₂CO₃, le LiCO₃, le KCO₃, le NaCO₃, le LiF, le CsF et le ZnSe.

6. Dispositif à clavier selon la revendication 2 dans lequel la couche transparente a une épaisseur qui est égale ou supérieure à 0,1 nm et inférieure à 100 nm.

7. Dispositif à clavier selon la revendication 2 dans lequel la couche organique comprend une couche de transport d'électrons qui est dopée avec l'un quelconque des éléments sélectionnés dans le groupe comportant les métaux à faible fonction de travail et les mélanges de ceux-ci pour faciliter l'injection d'électrons de la seconde électrode.

8. Dispositif à clavier selon la revendication 7 dans lequel les métaux à faible fonction de travail comprennent le Cs, le Li, le Na, K et le Ca.

9. Dispositif à clavier selon la revendication 7 dans lequel les mélanges comprennent Li-A. LiF, CsF et Cs2CO3.

10. Dispositif à clavier selon la revendication 2 dans lequel le panneau TOLED manifeste une transmission de l'ordre de 70 à 99% en fonction de la longueur d'onde (nm).

11. Dispositif mobile comprenant le dispositif à clavier énoncé dans l'une quelconque des revendications 1 à 10.

12. Procédé de commande d'un dispositif à clavier comprenant :
une unité de commande détectant un signal électrique relatif à un point de palpage du panneau tactile,
si le signal électrique généré dans le panneau tactile est détecté en faisant en sorte qu'un pixel correspondant émette de la lumière en appliquant une tension de commande au pixel correspondant du panneau TOLED correspondant au point de palpage,
**caractérisé par**
une feuille réfléchissante modelée avec des informations pour clavier réfléchissant des informations pour clavier correspondantes au pixel émettant de la lumière du panneau TOLED en affichant ces informations pour clavier.
